# EUROPEAN PATENT SPECIFICATION

(11) **EP 3 376 165 B1**
(45) Date of publication and mention of the grant of the patent: **27.03.2019**
(21) Application number: 17161454.8
(22) Date of filing: 16.03.2017
(51) Int. Cl.: G01D 4/16, G06T 7/13, G01R 21/00, B43L 13/00, G01R 19/12

(54) **POWER MONITOR**
LEISTUNGSÜBERWACHUNG
MONITEUR DE PUISSANCE

(43) Date of publication of application: 19.09.2018
(73) Proprietor: FUJITSU LIMITED, Nakahara-ku Kawasaki-shi Kanagawa 211-8588 (JP)
(72) Inventor: ZAHER, Ammar. S, Reading, RG2 0GR (GB)
(74) Representative: Haseltine Lake LLP

(56) References cited:
- WO-A1-2016/025990
- US-A1- 2010 094 476
- US-A1- 2013 054 039
- US-A1- 2014 172 772
- Anonymous: "Plotter - Wikipedia", , 9 February 2017 (2017-02-09), XP055399707, Retrieved from the Internet: URL:https://web.archive.org/web/2017020916 5323/https://en.wikipedia.org/wiki/Plotter [retrieved on 2017-08-18]

## Description

. A power monitoring apparatus, method and program for outputting power requirement information using an analysis of power usage information.

. In order to allow the amount of power required at any given time to be estimated, and thereby to allow the level of power being generated by a power station, generator and so on to be modulated, there is a demand for devices which allow the amount of power required to be estimated based on monitoring of current power use levels and predictions of future levels.

. The monitoring of power may be done across any suitable geographical or functional area. As an example of this, it is possible that it may be desired to monitor the power across all of the units in a light industrial estate, particularly where the light industrial estate uses a shared generator facility. In a further example, for an apartment building using a central generator facility to provide power to a plurality of individual apartments, it may also be desirable to monitor the power use such that the output of the central generator facility can be modulated. On a larger scale, it may be desired to monitor the power across an entire city such that the output of a plurality of power stations can be modulated, and on a smaller scale it may be desired to monitor the output from a single building or a single room such that the power generated by a more localised system (such as a solar power based system or a biomass generator) may be modulated, or alternatively such that the amount of power drawn from a power source such as a connection to a larger power grid can be modulated.

. In order to allow the level of power required to be estimated, it is possible to install a series of individual power monitors to monitor every potential power drain (that is, device requiring of a power supply or presenting a load) which may be located within a given geographical area (for example, a room, a building, a complex of buildings, a town or city and so on). Although this can provide a very accurate measure of the amount of power currently being used, and can therefore allow very accurate predictions of future power requirements to be made, the amount of data generated by monitoring the individual power usage for every potential power drain is very high. Therefore, obtaining and processing this information can be quite network and processing intensive. Also, the number of power monitors required to enact this level of monitoring is very high, and the level of monitoring could be considered invasive by some users.

. Accordingly, as an alternative to monitoring the level of power used by each individual device (which requires power, and is therefore a power drain) among a plurality of devices, it is known to alternatively provide a metering unit which monitors a specific geographic area (building, room, town/city, and so on) as a whole. Once the readings from the power meter monitoring the entire geographical area have been received, it is then possible to disaggregate the power readings in order to derive estimates for which device or devices may be operating at any given time. That is, by examining the power drain recorded by the meter, it is possible to identify which device or devices are currently operating, and to use predictions of the future power requirements of the devices in order to estimate a future power requirement for the geographical area.

. Whole building/area energy consumption can typically be obtained at various sampling rates using a smart meter device, which can record total energy consumptions. By using energy disaggregation algorithms it is possible to estimate individual device energy usage using less intrusive methods which do not require further expensive monitoring instrumentation to be installed at an individual device level.

. Utilising this information it is possible to provide benefits both for the consumer of energy (e.g., the user of the devices) and also for the generator of the energy. From the power user's perspective, knowledge of the drain of particular devices promotes energy conscious users to identify devices having a particularly high power drain, and to ration the use of these devices so as to minimise overall energy consumption, which has clear environmental benefits. From the operator's point of view, it allows for a more detailed information and patterns to be explored and commercially exploited regarding consumer energy demand, and also allows power stations to be run at an optimal level so as to not generate surplus energy (which may be wasted).

. Known energy disaggregation algorithms are typically designed to work using low sampling rate energy monitoring data. Known algorithms typically require, as a first step, detecting steady state operation events from within the aggregated signal in order to identify different device events within the aggregated signal. In order to effect this detection, known algorithms typically identify rising and falling edges within the energy consumption level, wherein a rising edge is indicative of the activation of a device and a falling edge is indicative of the deactivation of the device. Given the example of a domestic dwelling, the total power drain of the dwelling would rise if a particularly energy intensive device (for example, a kettle) was activated, and would then subsequently fall when the device was deactivated. By detecting these activation and deactivation events, existing energy disaggregation algorithms attempt to predict future usage.

. In order to extract useful information from an aggregated energy signal, existing disaggregation algorithms require detection of both a rising edge and a falling edge, and also the pairing of the rising edge and falling edge together. That is, it is necessary for the energy disaggregation algorithm to identify when a particular device has been turned on, and when the device has been turned off. This process may be complicated in the event where there are a plurality of devices having activation and deactivation periods which overlap. For example, in the event that in a domestic setting a microwave is activated, and then a kettle is activated while the microwave remains active, and then the kettle is deactivated still while the microwave remains active prior to the deactivation of the microwave, it may not be possible to distinguish the deactivation of the kettle from the deactivation of the microwave, and one or more of the activation and deactivation events may be overlooked. Incorrect identification of the rising and falling edges which pair with one another (that is, which are linked to the same device) could easily result in incorrect estimates of the future power drain.

. Further problems can arise due to noise in the aggregated signal which could lead to the difficulty in extracting isolated events originating from a single appliance within an aggregated signal. This can result in event features (such as the duration of an event, the energy consumed and the minimum and maximum power during an event) to be incorrectly identified by the energy disaggregation algorithm, resulting in inaccurate predictions for future energy requirements.

. A further issue for existing energy disaggregation algorithms is that some devices have complicated multistage power cycles. For example, a washing machine which has separate washing, spinning and drying cycles may have multiple different power drains at different times during the complete operation cycle (involving washing, spinning and drying), which may result in smoothed energy use profile with no clear power drain edge, or a rapid sequence of rising and falling edges which may be difficult for an energy disaggregation algorithm to resolve as originating from a single device.

. Accordingly, it is desirable to provide an energy monitoring apparatus which is capable of accurately disaggregating power use information to identify a power use signature from a single device from within an aggregated signal, thereby allowing more accurate predictions for future energy requirements to be made.

Document US2014172772 discloses a method of identifying an event associated with consumption of a utility, such as water, by identifying a group of events as events of a particular type when a probability density map corresponds to a stored profile of events of a particular type.

### Statements of Invention

. According to an example, there is provided a power monitoring apparatus comprising: an acquirer configured to acquire power usage information from a power meter; a plotter configured to plot the power usage information from the power meter; an edge detector configured to detect rising edges in the plot, and to select a portion of the power usage information on the basis of the detected rising edges; an encoder configured to generate a visual feature image using the portion of the power usage information selected by the edge detector; an analyser configured to analyse the visual feature image using image recognition to detect a device power consumption signature; and an outputter configured to output power requirement information using the detected device power consumption signature. The power monitoring apparatus provides a simplified method for detecting device power consumption signatures which is not prone to errors resulting from incorrect matching of rising and falling edges, and which is applicable to a broad range of devices.

. A further example provides a power monitoring apparatus wherein the edge detector is configured to determine the portion of the power usage information to select based on device power cycle information. By using the device power cycle information, the accuracy with which the portion of the power usage information is selected is improved.

. A further example provides a power monitoring apparatus wherein the encoder is configured to indicate the location of edges detected by the edge detector in the visual feature image. Indicating the location of the edges can improve the recognition of device power consumption signatures.

. A further example provides a power monitoring apparatus wherein the edge detector is configured to detect rising and falling edges in the plot. Detecting both rising and falling edges can also improve the recognition of device power consumption signatures.

. A further example provides a power monitoring apparatus wherein the analyser is configured to detect plural device power consumption signatures, and the outputter is configured to use the plural detected device power consumption signatures when outputting the power requirement information, thereby allowing the system to be more effectively and accurately used to monitor plural devices.

. A further example provides a power monitoring apparatus wherein the power usage information is for a specific geographic area. The specific geographic area may be a building or a part of a building, or a larger area, depending on the precise power monitoring requirements. In this way, the power monitoring apparatus can be tailored for a specific situation.

. A further example provides a power monitoring apparatus that includes the power meter, and wherein the power monitoring apparatus is located in the specific geographic area. The resulting apparatus is self-contained, and is not reliant on communication using networks, potentially improving the reliability of the device.

. A further example provides a power monitoring apparatus located remote from the specific geographic area, in particular wherein acquirer is configured to acquire the power usage information via a network. This allows decentralised operation, wherein a single power monitoring apparatus can receive information from a large number of meters and can monitor a large specific geographic area.

. A further example provides a power monitoring apparatus comprising a controller configured to control a power source using the power requirement information outputted by the outputter. This allows the power source to directly respond to current and predicted power load, allowing for more responsive power generation that meets power requirements without the generation of excess power.

. According to further examples there are provided methods for implementing the functions described above in the context of the examples of the power monitoring apparatus. The methods provide the same advantages as described above with reference to the examples of the power monitoring apparatus.

. According to further examples, there are provided computer-readable media comprising computer programs which, when executed by a computing apparatus, causes the computing apparatus to execute a method as described above. This provides the advantage of an easy and efficient way to implement a method as described above.

### Description of Figures

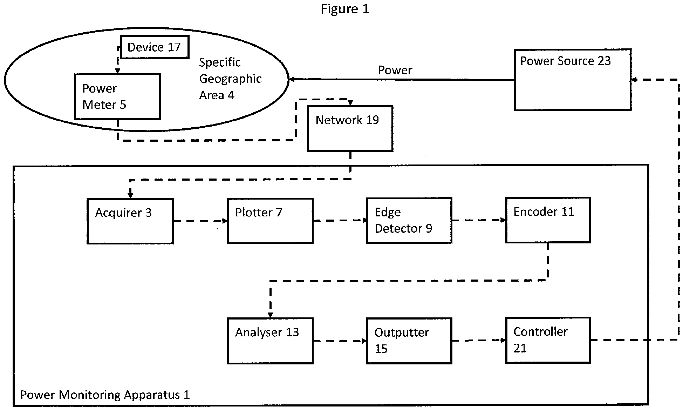

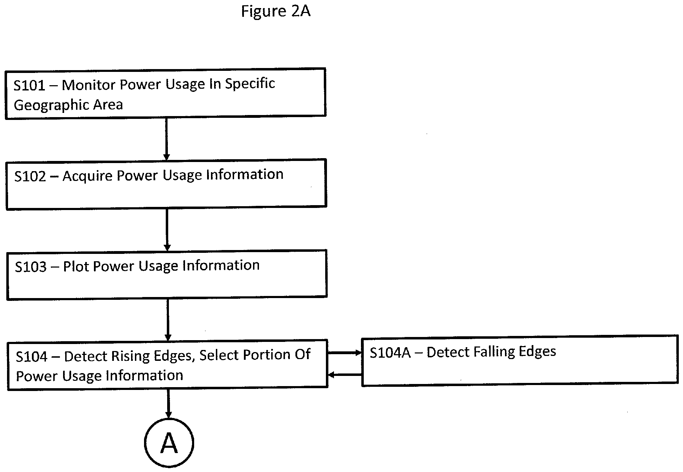

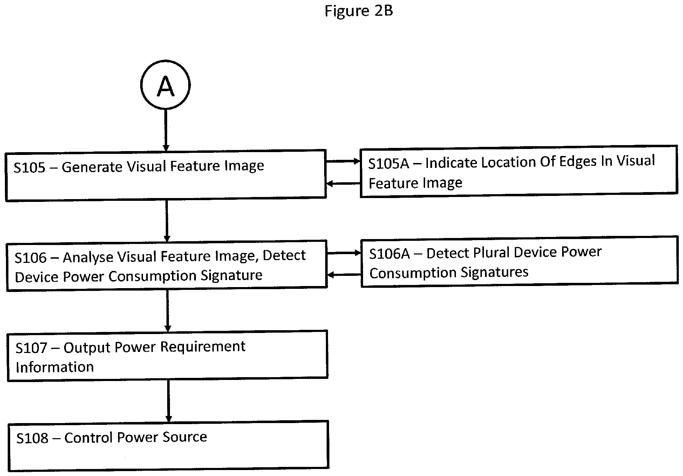

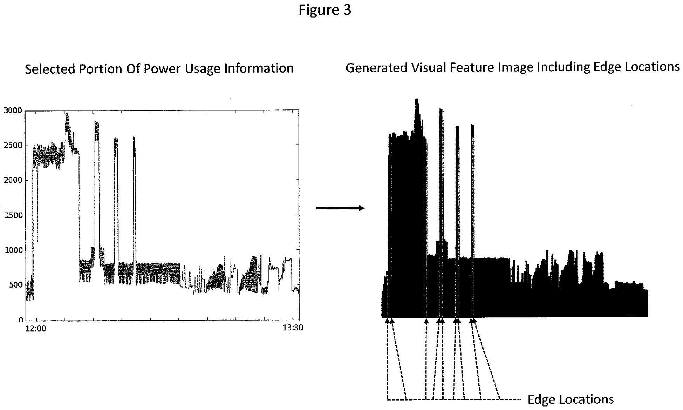

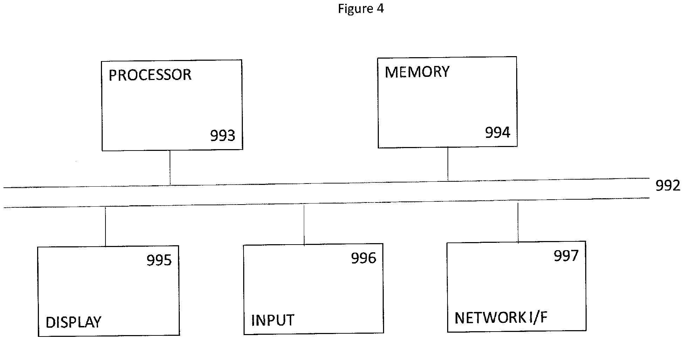

. The invention will now be further described, by way of example only, with reference to the following figures, in which:
. Figure 1 is a schematic representation of an example of a power monitoring apparatus.
. Figure 2A is a flowchart showing a first part of an example of a method for monitoring power consumption.
. Figure 2B is a flowchart showing a second part of the example of a method for monitoring power consumption.
. Figure 3 is a diagram illustrating an example of the generation of a visual feature image from a selected portion of power usage information.
. Figure 4 is a schematic representation of a computing device that may be used to implement methods for monitoring power consumption.

### Detailed Description

. The schematic diagram in Figure 1 shows an example of a power monitoring apparatus 1. The power monitoring apparatus 1 is configured to monitor the power usage within a specific geographic area 4. In the examples shown in Figure 1, the power monitoring apparatus 1 is located remote from (outside) the specific geographic area 4 that it is configured to monitor. That is, the power monitoring apparatus 1 is not located in the specific geographic area 4 in the example shown in Figure 1. However, it is possible for the power monitoring apparatus 1 to be located within a specific geographic area 4 which it monitors. In cases wherein the power monitoring apparatus 1 is located in a specific geographic area 4 which is used to monitor, the power monitoring apparatus 1 may comprise a power meter 5. Alternatively, the power meter 5 may be separate from but connected to the power monitoring apparatus 1. In the example shown in Figure 1, the power meter 5 is separate from the power monitoring apparatus 1 (which is outside the specific geographic area 4), and is connected to the power monitoring apparatus 1 via a network 19. In the example shown in Figure 1, the network 19 is the internet, however any suitable network of wired or wireless connections may be utilised.

. A device 17 is located in the specific geographic area 4. For ease of understanding, in the following example the power monitoring apparatus 1 is used to extract the power signature of a single device 17 from the aggregated signal of the power using devices within the specific geographic area 4. However, as discussed in greater detail below, the power monitoring apparatus 1 may also be used to extract the power use signatures of plural devices within the specific geographic area 4. The particular functionality of the power monitoring apparatus 1 can be configured depending upon the particular requirements of the system in which it is used. Different specific geographic areas 4 include different number of devices 17. The total number of devices 17 may vary between a single device 17 and several hundred or thousand devices 17.

. The amount of power used by all of the devices within the specific geographic area 4 (including the device 17 for which it is desired to extract a power signature) is monitored by the power meter 5. This is indicated by step S101 in Figure 2A. The frequency with which the power meter 5 monitors the power usage and sends this information to the power monitoring apparatus 1 is determined by the particular requirements of the system; for most applications a reading frequency of one reading per minute is sufficient. In the event that is it desired to obtain a more precise monitoring of the power usage, it is possible to monitor this power usage more frequently. Alternatively, in the event that small fluctuations in the power usage are of less importance and it is more desired to identify general trends in the power usage, a less frequent monitoring frequency may be used.

. The power monitoring information is typically output from the power meter 5 in the form of a total power being used at a given time, however the power monitoring apparatus 1 may be configured to use the output from one or more power meters 5 in any suitable format, depending on the specific requirements of the system. The total power used can be output in units of watts (W, joules per second), or alternatively depending on the total power used, in megawatts (MW), kilowatts (kW), milliwatts (mW), and so on. As discussed above, the time interval between readings is varied depending upon the level of precision required; typically a reading is obtained every minute. The power used by all of the devices monitored by the power meter 5 generate the aggregated power usage information. The aggregated power usage information is acquired by the power monitoring apparatus 1, specifically by the acquirer 3, as shown in step S102 of Figure 2A. The mechanism by which the acquirer 3 acquires this information varies between power monitoring apparatuses 1. In the example shown in Figure 1, the power usage information is transmitted from the power meter 5 (which monitors the power usage within the specific geographic area) via the network 19 (the internet in this example) to the acquirer 3. However, in a situation where the power monitoring apparatus 1 is located within or in close proximity to the specific geographic area 4, and in particular wherein the power monitoring apparatus 1 includes the power meter 5, the information may be transmitted directly from the power meter 5 to the acquirer 3.

. Once the power monitoring information has been acquired by the acquirer 3, this information is then passed on to the plotter 7 such that the plotter 7 may form a plot of the power usage information. This is indicated by step S103 in Figure 2A. In the event that the amounts of information available is larger than is required, the power usage information may be sampled. For example, in the event that the power usage information obtained by the acquirer 3 contains a reading for every second of operation, but it is only desired to plot the power usage information with a reading for every minute of operation, the plotter 7 may be configured to take every 60^{th} reading (equivalent to taking one reading per minute) and to form a plot using this information. Additionally or alternatively, in the event that there has been an interruption in the power usage information such that some readings have been omitted, it is possible for the plotter 7 to take this into account and assume, for example, a constant level or constant gradient of change between the last correctly obtained reading before an omitted reading (or readings) and a first correctly obtained reading after an omitted reading (or readings). In this way, a small interruption in the power usage information does not drastically alter the operation of the power monitoring apparatus 1.

. Once a plot of the power usage information has been formed by the plotter 7, this plot is then evaluated by the edge detector 9 in order to detect rising edges in the plot. This is illustrated in Figure 2A by step S104. As discussed briefly above, the rising edges are typically indicative of the activation of a device 17, causing a rapid increase in the total amount of power used. Any suitable methodology may be used to detect the rising edges; an example of a suitable edge detection algorithm is shown below (in Algorithm 1), wherein W is the minimum magnitude of an increase in the recorded power between two successive readings, or over a given range of readings, in order for a rising edge to be detected. Once a rising edge has been detected, Algorithm 1 is configured to identify subsequent edges (rising and falling), but not to attempt to pair rising and falling edges together.

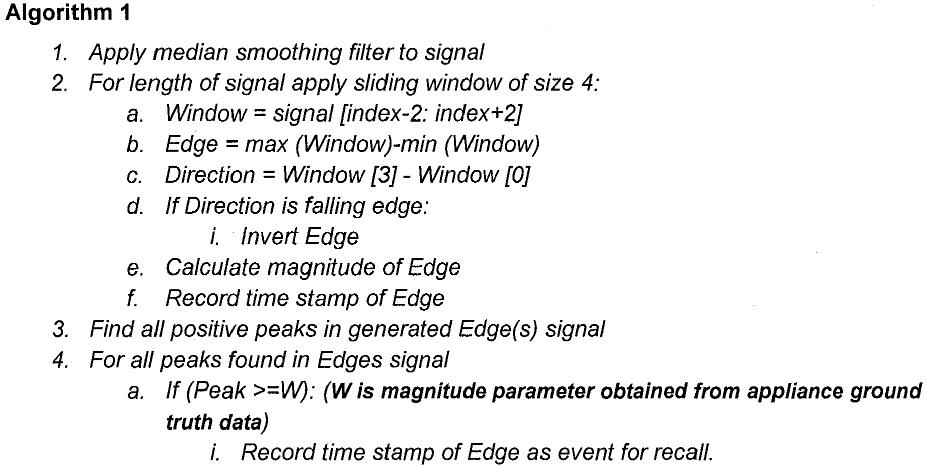

. Algorithm 1 is an example of an algorithm that may be used, alternative techniques may be used depending on the specific requirements of a power monitoring apparatus 1.

. Following the detection of a rising edge, the edge detector 9 is then configured to select a portion of the power usage information on the basis of the detected rising edge or rising edges in the plot. That is, the edge detector 9 extracts a portion of the power usage information in the vicinity of the detected rising edge, such that this portion of the power usage information can be further analysed in order to attempt to identify the power signature of a device 17. The selected portion is usually a portion including and subsequent to the detected rising edge, however this is not always the case. For example, in cases wherein the device has a complex power usage signature involving multiple different power usage levels, a detected rising edge may not be indicative of the initial activation of the device, and accordingly a portion of the power usage information preceding the detected rising edge, and/or potentially not including the detected rising edge, may also be selected as the selected portion.

. In the event that it is desired to identify the power usage signatures of plural devices, or wherein there are plural edges which may be indicative of the activation of one or more devices (or wherein one or more of the devices may have been activated or deactivated in rapid succession, or wherein one or more of the edges may result from random noise rather than an actual activation or deactivation of a device 17), the plotter 7 may be configured to extract plural portions of the power usage information for subsequent analysis by the remaining components of the power monitoring apparatus 1.

. As discussed above, prior art systems require the identification of rising and falling edges in power aggregation signals in order to attempt to disaggregate the power signatures of individual devices from the aggregated signals. By contrast, the power monitoring apparatus 1 can utilise only the identification of rising edges, and does not require falling edges to be identified in order to disaggregate the aggregated power usage information. However, the edge detector 9 may be configured to identify falling edges (in addition to rising edges), and to also pass the identification of this information onto the further components of the power monitoring apparatus 1. The identification of the falling edges can be used to build a further profile of the device power usage signature, as discussed in greater detail below. The detection of the falling edges is indicated by step S104A in Figure 2A.

. In an alternative configuration, falling edges may be exclusively used to disaggregate the aggregated power usage information (not in conjunction with rising edges). Where falling edges are used to disaggregate the aggregated power usage information, it is generally necessary to perform ongoing storage of the aggregated power usage information so that, when a falling edge is detected, a portion of the aggregated power usage information taken from before the detection of the falling edge can be extracted and passed to the encoder, to ultimately be analysed for device power usage signatures. The aggregated power usage information may be stored in a buffer, and continually replaced with more recent aggregated power usage information. As the use of falling edges to disaggregate the aggregated power usage information requires storage of past aggregated power usage information, typically rising edges are used (either alone or in conjunction with falling edges), such that storage of the aggregated power usage information need not necessarily be provided.

. The selected portion of the power usage information is then passed to an encoder 11, which is used to generate a visual feature image using the portion of the power usage information as selected by the edge detector 9. This process is indicated by step S105 in Figure 2B. An example of the generation of a visual feature image from a selected portion of power usage information is shown in Figure 3 of the application. While the selected portion of the power usage information may be passed to the encoder 11 in any suitable form (as a stream of numerical data, as a table, as a graph, and so on), the feature image generated by the encoder is a visual feature image. By generating a visual feature image from the selected portion of the power usage information, the problem of identifying power usage signatures of the devices is altered from a primarily numerical analysis problem to a primarily visual image recognition/analysis problem, allowing image based classification methodology (including image recognition techniques) to be applied to the problem. This is discussed in greater detail below with reference to the analyser 13.

. In the generation of the visual feature image, typically the area underneath a power usage information plot (which plots the total power on the y axis and time on the x axis; Figure 3 uses arbitrary units to illustrate this point) may be shaded in. This is because some image classification techniques which may be used to analyse the visual feature image are more effective in instances wherein the contrast between the area encompassed by the power usage information and the area outside the power usage information is more defined. As illustrated in step 105A in Figure 2B, the encoder 11 may also be configured to highlight the locations of the edges in the visual feature image. In the event that only the rising edges (or falling edges) are detected, only these edges may be highlighted. Alternatively, if both the rising and the falling edges are detected, both of the rising and falling edges may be highlighted or again, simply the rising edges may be highlighted. In the event where both of the rising and falling edges are highlighted, these may be highlighted in different colours in order to further enhance the distinction between these edges. In the example shown in Figure 3, both the rising and falling edges have been highlighted, both in the same colour.

. Once the visual feature image has been generated by the encoder 11, and optionally wherein the locations of the edges in the visual feature image have been indicated, the visual feature image is then passed to the analyser 13 for analysis. The analyser 13 is configured to identify within the visual feature image the power signature for a specific device 17 (or power signatures for specific devices in the event that this is how the power monitoring apparatus 1 is configured). The detection of a (single) device power consumption signature is indicated by step S106 in Figure 2B, while the detection of plural device power consumption signatures is indicated by step S106A in Figure 2B. The analyser 13 is effectively configured to provide an image analysis, and as such may apply known image analysis techniques.

. In the examples shown in Figure 1, the analyser 13 is configured to utilise a neural network in order to analyse the visual feature image with the aim of extracting device power consumption signatures. Where a neural network is used, it is necessary to train the neural network in order to identify the specific device power signatures. A typical machine learning model training and testing procedure (which requires prior knowledge of device power signatures) may be used in order to train the neural network. Once the neural network has been trained using sufficient examples of the power signature of a given device 17 (or devices), the neural network can then be used to detect previously unseen instances of the power signature from a noisy aggregate energy consumption signal.

. Although a neural network is utilised in the present example, alternative image analysis systems such as edge detection or blob discovery based systems operating using computers or FPGA systems may also be used. Various coding languages, such as C++, Python, Java and so on may be used to perform visual image analysis, potentially through the use of functions from established libraries such as OpenCV. The nature of the image analysis system to be used in a given embodiment of the power monitoring apparatus 1 can be determined based on the specific requirements of the system, including the approximate number of devices which may be represented in the aggregated power usage information, the time scale of the selected portion, and so on.

. Because of the way in which the neural network operates (specifically by identifying particular feature within an image), the highlighting of edges within a visual feature image can improve the accuracy of the neural network. However, this is not a requirement of the use of a neural network, and visual feature images wherein the edges are not highlighted may also utilise an analyser 13 based on a neural network. Generally, image based classifiers respond to more feature rich images, that is, images having less background white space. For this reason, the area underneath the power usage information plot can be filled in as discussed above.

. In order to identify the power usage signature of a particular device 17, the analyser 13 may look for the points of transition between a high load and a low load within the signal. Because the analyser 13 is configured to look for the transitions (and the separation between transitions) and not to focus on, for example, the absolute total power drain of all of the devices within the specific geographic area 4 at any given time, the analyser 13 can extract the signature for the device 17 from a signal containing a large number of other information points from other devices, or from background noise. In particular, the spacing of the transitions between high and low power are indicative of a particular device's operation cycle. Returning to the example of the washing machine, a spike in power may be expected wherein the washing machine reaches the point in the cycle wherein a heating cycle is activated, and a falling edge may be expected when this heating cycle ends. Because the operation of the power monitoring apparatus 1 (in particular the analyser 13) involves building a model for each device 17, and because the analyser 13 may extract a large number of different visual features from any given visual feature image, it is possible to distinguish a large number of device signatures from power usage information. The analyser 13 may be configured to detect only a fraction of a device power consumptions signature, such as a starting fraction of the signature or a fraction not including the start or end of the signature, which can be particularly useful when predicting future power requirements.

. In events wherein a particular device signature is not available for training the analyser 13 (particularly wherein the analyser 13 utilises a neural network), it is possible for the analyser 13 to estimate the device signature for a given device 17 based on known device signatures for similar devices. For example, wherein the power consumption signature for a particular model of washing machine (model A) is not known, the analyser 13 may estimate the device signature for the unknown washing machine (model A) based on known power signatures for further examples of washing machines (models B, C, D etc.). However the use of an estimated device signature in this way will, by definition, be less accurate than the use of a fully known device signature, and therefore the analyser 13 will typically favour using the correct signature for a device over utilising the estimating technique.

. Once the analyser 13 has analysed the visual feature image and detected a device power consumption signature, this information can then be passed onto an outputter 15 to output power requirement information on the basis of the detected device 17 (or devices) power consumption signature(s). That is, in the event that the analyser 13 detects the beginning of a power cycle of a device 17 known to be particularly demanding of power later in the cycle, this information can be outputted by the outputter 15. The outputting is indicated by step S107 in Figure 2B. On the basis of the outputted information, a power source 23 may be prepared to supply enough power to meet requirements. For example, to account for an expected spike in power demand, a further generator may automatically be activated in order to ensure that sufficient power is available, or a request may be submitted to a larger power grid for a larger supply of power.

. Optionally, the power monitoring apparatus 1 may include a controller 21 which is linked to the outputter 15 and which is configured to control a power source 23 on the basis of the output from the outputter 15 (as indicated in step S108 of Figure 2B). This configuration may be particularly appropriate in cases where the power source 23 is operated on a comparatively small scale and local to the power monitoring apparatus 1. As an example of this, the power source 23 may be a generator or generators within a single industrial complex also containing the power monitoring apparatus 1. In cases wherein the power monitoring apparatus 1 is utilised over a broader geographical area (for example, a town) and wherein the power source 23 is one or more power stations, it may not be appropriate for the controller 21 to be directly linked to the power source 23 as other considerations may take precedence over the expected increase or decrease in power demand.

. As discussed in detail above, the operation of the power monitoring apparatus 1 provides numerous advantages relative to known techniques. Because the power monitoring apparatus 1 requires only the detection of rising edges, rather than the detection of rising and falling edges and the pairing of rising and falling edges, the operation of the power monitoring apparatus 1 is more reliable for aggregated signals. This is particularly the case when the aggregated signal may contain noise, because the presence of noise may make the pairing of rising and falling edges (as is a requirement of prior art systems) particularly challenging, but does not unduly hamper the power monitoring apparatus 1. Further, the operation of the power monitoring apparatus 1 is based at least in part on the use of an analyser 13 which can learn specific power signatures. This provides numerous advantages, including that the power monitoring apparatus 1 can be taught to recognise new devices in the event that new devices are included in the specific geographic area 4 which the power monitoring apparatus 1 is used to monitor. Also, the analyser 13 may become more accurate with use as more power consumption signatures are detected for devices, because the analyser 13 will more narrowly refine the parameters of a given device power consumption signature to allow this signature to be more accurately identified from background noise. Also, by linking the power monitoring apparatus 1 directly to a power source 23, it is possible to provide an overall system wherein the power demands of devices are anticipated and automatically provided for, such that it is less common for power demand to outstrip available power supply.

. Although the above text discusses the use of a power monitoring apparatus 1, it will be appreciated that several of the features may be implemented using a computer program operating on a suitable computer. In particular, the computer may be operable to acquire the power usage information from a power meter 5, and then to provide all of the steps necessary prior to outputting the power requirement information using the outputter 15 (on the basis of detected device power consumption signature or signatures), or may alternatively be linked directly to a power source 23 such that the computer may be used to control the power source 23 using the power requirement information outputted by the outputter 15.

. Figure 4 is a block diagram of a computing device, such as a personal computer, which may be used to implement power monitoring as discussed above. The computing device comprises a processor 993, and memory 994. Optionally, the computing device also includes a network interface 997 for communication with other computing devices, for example with other computing devices of embodiments, or for computing with remote power meters 5.

. For example, an aspect of an embodiment may be composed of a network of such computing devices, such that components of the power monitoring apparatus 1 are split across a plurality of computing devices. In particular, where the analyser 13 utilises a neural network, this neural network may be implemented by a plurality of interconnected computing devices. Optionally, the computing device also includes one or more input mechanisms such as keyboard and mouse or touchscreen interface 996 and a display unit such as one or more monitors 995. The components are connectable to one another via a bus 992.

. The memory 994 may include a computer readable medium, which term may refer to a single medium or multiple media (e.g., a centralized or distributed database and/or associated caches and servers) configured to carry computer-executable instructions or have data structures stored thereon. Computer-executable instructions may include, for example, instructions and data accessible by and causing a general purpose computer, special purpose computer, or special purpose processing device (e.g., one or more processors) to perform one or more functions or operations. Thus, the term "computer-readable storage medium" may also include any medium that is capable of storing, encoding or carrying a set of instructions for execution by the machine and that cause the machine to perform any one or more of the methods of the present disclosure. The term "computer-readable storage medium" may accordingly be taken to include, but not be limited to, solid-state memories, optical media and magnetic media. By way of example, and not limitation, such computer-readable media may include non-transitory computer-readable storage media, including Random Access Memory (RAM), Read-Only Memory (ROM), Electrically Erasable Programmable Read-Only Memory (EEPROM), Compact Disc Read-Only Memory (CD-ROM) or other optical disk storage, magnetic disk storage or other magnetic storage devices, flash memory devices (e.g., solid state memory devices).

. The processor 993 is configured to control the computing device and execute processing operations, for example executing code stored in the memory to implement the various different functions of the acquirer 3, plotter 7, edge detector 9, encoder 11, analyser 13, outputter 15, controller 21 and power meter 5 described here and in the claims. The memory 994 stores data being read and written by the processor 993. As referred to herein, a processor may include one or more general-purpose processing devices such as a microprocessor, central processing unit, or the like. The processor may include a complex instruction set computing (CISC) microprocessor, reduced instruction set computing (RISC) microprocessor, very long instruction word (VLIW) microprocessor, or a processor implementing other instruction sets or processors implementing a combination of instruction sets. The processor may also include one or more special-purpose processing devices such as an application specific integrated circuit (ASIC), a field programmable gate array (FPGA), a digital signal processor (DSP), network processor, or the like. In one or more embodiments, a processor is configured to execute instructions for performing the operations and steps discussed herein.

. The display unit 997 may display a representation of data stored by the computing device and may also display a cursor and dialog boxes and screens enabling interaction between a user and the programs and data stored on the computing device. The display unit may also comprise a touchscreen interface.

. The network interface (network I/F) 997 may be connected to a network, such as the Internet, and is connectable to other such computing devices via the network 19. The network I/F 997 may control data input/output from/to other apparatus via the network 19.

. Other peripheral devices such as microphone, speakers, printer, power supply unit, fan, case, scanner, trackerball etc. may be included in the computing device.

. The acquirer 3 of Figure 1 may be a processor 993 (or plurality thereof) executing processing instructions (a program) stored on a memory 994 and exchanging data via a network I/F 997 or bus 992. In particular, the processor 993 may execute processing instructions to acquire, via the network I/F 997 or bus 992, power usage information as discussed above. Furthermore, the processor 993 may execute processing instructions to store the acquired power usage information on a connected storage unit and/or to transmit, via the network I/F 997 or bus 992, the acquired power usage information to a plotter 7.

. The plotter 7 of Figure 1 may be a processor 993 (or plurality thereof) executing processing instructions (a program) stored on a memory 994 and exchanging data via a network I/F 997 or bus 992. In particular, the processor 993 may execute processing instructions to receive, via the network I/F 997 or bus 992, power usage information and plot the power usage information as discussed above. Furthermore, the processor 993 may execute processing instructions to store plots on a connected storage unit and/or to transmit, via the network I/F 997 or bus 992, the plots to an edge detector 9.

. The edge detector 9 of Figure 1 may be a processor 993 (or plurality thereof) executing processing instructions (a program) stored on a memory 994 and exchanging data via a network I/F 997 or bus 992. In particular, the processor 993 may execute processing instructions to receive, via the network I/F 997 or bus 992, the plots as discussed above. Furthermore, the processor 993 may execute processing instructions to detect rising edges in the plots, to select a portion of the power usage information on the basis of the detected rising edges, and to store the selected portion on a connected storage unit and/or to transmit, via the network I/F 997 or bus 992, the selected portion to an encoder 11.

. The encoder 11 of Figure 1 may be a processor 993 (or plurality thereof) executing processing instructions (a program) stored on a memory 994 and exchanging data via a network I/F 997 or bus 992. In particular, the processor 993 may execute processing instructions to receive, via the network I/F 997 or bus 992, the selected portion as discussed above. Furthermore, the processor 993 may execute processing instructions to generate a visual feature image using the portion of the power usage information selected by the edge detector 9 and to store the visual feature image on a connected storage unit and/or to transmit, via the network I/F 997 or bus 992, the visual feature image to an analyser 13.

. The analyser 13 of Figure 1 may be a processor 993 (or plurality thereof) executing processing instructions (a program) stored on a memory 994 and exchanging data via a network I/F 997 or bus 992. In particular, the processor 993 may execute processing instructions to receive the visual feature image and analyse the visual feature image to detect a device power consumption signature (or plural device power consumption signatures) as discussed above. Furthermore, the processor 993 may execute processing instructions to store the detected device power consumption signature or signatures on a connected storage unit and/or to transmit, via the network I/F 997 or bus 992, the signature or signatures to an outputter 15.

. The outputter 15 of Figure 1 may be a processor 993 (or plurality thereof) executing processing instructions (a program) stored on a memory 994 and exchanging data via a network I/F 997 or bus 992. In particular, the processor 993 may execute processing instructions to receive the signature or signatures from the analyser 13 as discussed above. Furthermore, the processor 993 may execute processing instructions to generate power requirement information using the signature or signatures, and to store the detected device power consumption signature or signatures on a connected storage unit and/or to output, via the network I/F 997 or bus 992, the power requirement information to a further component, such as a controller 21.

. Methods may be carried out on a computing device such as that illustrated in Figure 4. Such a computing device need not have every component illustrated in Figure 4, and may be composed of a subset of those components. A method may be carried out by a single computing device in communication with one or more data storage servers via a network 19, as discussed above.

. For the avoidance of doubt, the scope of the invention is defined by the claims.

## Claims

1. A power monitoring apparatus comprising:
an acquirer configured to acquire power usage information from a power meter;
a plotter configured to plot the power usage information from the power meter;
an edge detector configured to detect rising edges in the plot, and to select a portion of the power usage information on the basis of the detected rising edges;
an encoder configured to generate a visual feature image using the portion of the power usage information selected by the edge detector;
an analyser configured to analyse the visual feature image using image recognition to detect a device power consumption signature; and
an outputter configured to output power requirement information using the detected device power consumption signature.

2. The power monitoring apparatus of claim 1, wherein the edge detector is configured to determine the portion of the power usage information to select based on device power cycle information.

3. The power monitoring apparatus of any of claims 1 and 2, wherein the encoder is configured to indicate the location of edges detected by the edge detector in the visual feature image.

4. The power monitoring apparatus of any of claims 1 to 3, wherein the edge detector is configured to detect rising and falling edges in the plot.

5. The power monitoring apparatus of any of claims 1 to 4, wherein the analyser is configured to detect plural device power consumption signatures, and the outputter is configured to use the plural detected device power consumption signatures when outputting the power requirement information.

6. The power monitoring apparatus of any of claims 1 to 5, wherein the power usage information is for a specific geographic area.

7. The power monitoring apparatus of claim 6, wherein the specific geographic area is a building.

8. The power monitoring apparatus of claim 6, wherein the specific geographic area is a part of a building.

9. The power monitoring apparatus of any of claims 6 to 8, wherein the power monitoring apparatus includes the power meter, and wherein the power monitoring apparatus is located in the specific geographic area.

10. The power monitoring apparatus of any of claims 6 to 8, wherein the power monitoring apparatus is located remote from the specific geographic area.

11. The power monitoring apparatus of claim 10, wherein the acquirer is configured to acquire the power usage information via a network.

12. The power monitoring apparatus of any preceding claim, further comprising a controller configured to control a power source using the power requirement information outputted by the outputter.

13. A method for monitoring power consumption, the method comprising the steps of:
acquiring power usage information from a power meter;
plotting the power usage information from the power meter;
detecting rising edges in the plot, and selecting a portion of the power usage information on the basis of the detected rising edges;
generating a visual feature image using the selected portion of the power usage information;
analysing the visual feature image using image recognition to detect a device power consumption signature; and
outputting power requirement information using the detected device power consumption signature.

14. A computer program which, when executed by a computer, causes the computer to perform the method for monitoring power consumption of claim 13.

15. A computer-readable medium comprising the computer program of claim 14.

## Patentansprüche

1. Energieüberwachungsvorrichtung, Folgendes umfassend:
eine Erfassungseinrichtung, die dafür konfiguriert ist, Energieverwendungsinformationen von einem Energiemesser zu erfassen,
einen Plotter, der dafür konfiguriert ist, die Energieverwendungsinformationen von dem Energiemesser zu plotten,
einen Flankendetektor, der dafür konfiguriert ist, steigende Flanken in dem Plot zu detektieren und auf der Basis der detektierten steigenden Flanken einen Teil der Energieverwendungsinformationen auszuwählen,
einen Encoder, der dafür konfiguriert ist, mit Hilfe des Teils der Energieverwendungsinformationen, die durch den Flankendetektor ausgewählt werden, ein Bild visueller Merkmale zu erzeugen,
einen Analysator, der dafür konfiguriert ist, mit Hilfe von Bilderkennung das Bild visueller Merkmale zu analysieren, um eine Geräte-Energieverbrauchssignatur zu detektieren, und
eine Ausgabeeinrichtung, die dafür konfiguriert ist, mit Hilfe der detektierten Geräte-Energieverbrauchssignatur Energieanforderungsinformationen auszugeben.

2. Energieüberwachungsvorrichtung nach Anspruch 1, wobei der Flankendetektor dafür konfiguriert ist, den Teil der Energieverwendungsinformationen, der auszuwählen ist, basierend auf Geräte-Energiezyklusinformationen zu bestimmen.

3. Energieüberwachungsvorrichtung nach einem der Ansprüche 1 und 2, wobei der Encoder dafür konfiguriert ist, die Position von Flanken, die durch den Flankendetektor detektiert werden, in dem Bild visueller Merkmale anzugeben.

4. Energieüberwachungsvorrichtung nach einem der Ansprüche 1 bis 3, wobei der Flankendetektor dafür konfiguriert ist, steigende und fallende Flanken in dem Plot zu detektieren.

5. Energieüberwachungsvorrichtung nach einem der Ansprüche 1 bis 4, wobei der Analysator dafür konfiguriert ist, mehrere Geräte-Energieverbrauchssignaturen zu detektieren, und die Ausgabeeinrichtung dafür konfiguriert ist, die mehreren Geräte-Energieverbrauchssignaturen beim Ausgeben der Energieanforderungsinformationen zu verwenden.

6. Energieüberwachungsvorrichtung nach einem der Ansprüche 1 bis 5, wobei die Energieverwendungsinformationen für einen spezifischen geografischen Bereich sind.

7. Energieüberwachungsvorrichtung nach Anspruch 6, wobei der spezifische geografische Bereich ein Gebäude ist.

8. Energieüberwachungsvorrichtung nach Anspruch 6, wobei der spezifische geografische Bereich ein Teil eines Gebäudes ist.

9. Energieüberwachungsvorrichtung nach einem der Ansprüche 6 bis 8, wobei die Energieüberwachungsvorrichtung den Energiemesser beinhaltet und wobei sich die Energieüberwachungsvorrichtung in dem spezifischen geografischen Bereich befindet.

10. Energieüberwachungsvorrichtung nach einem der Ansprüche 6 bis 8, wobei sich die Energieüberwachungsvorrichtung fern des spezifischen geografischen Bereichs befindet.

11. Energieüberwachungsvorrichtung nach Anspruch 10, wobei die Erfassungseinrichtung dafür konfiguriert ist, die Energieverwendungsinformationen über ein Netzwerk zu erfassen.

12. Energieüberwachungsvorrichtung nach einem vorhergehenden Anspruch, ferner eine Steuerung umfassend, die dafür konfiguriert ist, mit Hilfe der von der Ausgabeeinrichtung ausgegebenen Energieanforderungsinformationen eine Energiequelle zu steuern.

13. Verfahren zum Überwachen des Energieverbrauchs, wobei das Verfahren folgende Schritte umfasst:
Erfassen von Energieverwendungsinformationen von einem Energiemesser,
Plotten der Energieverwendungsinformationen von dem Energiemesser,
Detektieren steigender Flanken in dem Plot und Auswählen eines Teils der Energieverwendungsinformationen auf der Basis der detektierten steigenden Flanken,
Erzeugen eines Bildes visueller Merkmale mit Hilfe des ausgewählten Teils der Energieverwendungsinformationen,
Analysieren des Bildes visueller Merkmale mit Hilfe von Bilderkennung, um eine Geräte-Energieverbrauchssignatur zu detektieren, und
Ausgeben von Energieanforderungsinformationen mit Hilfe der detektierten Geräte-Energieverbrauchssignatur.

14. Computerprogramm, das bei Ausführung durch einen Computer den Computer veranlasst, das Verfahren zum Überwachen des Energieverbrauchs nach Anspruch 13 durchzuführen.

15. Computerlesbares Medium, das Computerprogramm nach Anspruch 14 umfassend.

## Revendications

1. Appareil de surveillance d'énergie comprenant :
un acquéreur configuré pour acquérir des informations d'utilisation d'énergie à partir d'un dispositif de mesure d'énergie ;
un traceur configuré pour tracer les informations d'utilisation d'énergie provenant du dispositif de mesure d'énergie ;
un détecteur de fronts configuré pour détecter des fronts montants dans le tracé, et pour sélectionner une partie des informations d'utilisation d'énergie sur la base des fronts montants détectés ;
un codeur configuré pour générer une image de caractéristique visuelle en utilisant la partie des informations d'utilisation d'énergie sélectionnées par le détecteur de fronts ;
un analyseur configuré pour analyser l'image de caractéristique visuelle en utilisant une reconnaissance d'image pour détecter une signature de consommation d'énergie de dispositif ; et
un dispositif de sortie configuré pour délivrer en sortie des informations de besoin en énergie en utilisant la signature détectée de consommation d'énergie de dispositif.

2. Dispositif de surveillance d'énergie selon la revendication 1, dans lequel le détecteur de fronts est configuré pour déterminer la partie des informations d'utilisation d'énergie à sélectionner sur la base d'informations de cycle d'énergie de dispositif.

3. Appareil de surveillance d'énergie selon l'une quelconque des revendications 1 et 2, dans lequel le codeur est configuré pour indiquer l'emplacement de fronts détectés par le détecteur de fronts dans l'image de caractéristique visuelle.

4. Dispositif de surveillance d'énergie selon l'une quelconque des revendications 1 à 3, dans lequel le détecteur de fronts est configuré pour détecter des fronts montants et descendants dans le tracé.

5. Appareil de surveillance d'énergie selon l'une quelconque des revendications 1 à 4, dans lequel l'analyseur est configuré pour détecter plusieurs signatures de consommation d'énergie de dispositif, et le dispositif de sortie est configuré pour utiliser les plusieurs signatures détectées de consommation d'énergie de dispositif lorsqu'il délivre en sortie les informations de besoin en énergie.

6. Appareil de surveillance d'énergie selon l'une quelconque des revendications 1 à 5, dans lequel les informations d'utilisation d'énergie sont destinées à une zone géographique spécifique.

7. Appareil de surveillance d'énergie selon la revendication 6, dans lequel la zone géographique spécifique est un bâtiment.

8. Appareil de surveillance d'énergie selon la revendication 6, dans lequel la zone géographique spécifique est une partie d'un bâtiment.

9. Appareil de surveillance d'énergie selon l'une quelconque des revendications 6 à 8, dans lequel l'appareil de surveillance d'énergie comprend le dispositif de mesure d'énergie, et dans lequel l'appareil de surveillance d'énergie est situé dans la zone géographique spécifique.

10. Appareil de surveillance d'énergie selon l'une quelconque des revendications 6 à 8, dans lequel l'appareil de surveillance d'énergie est situé à distance de la zone géographique spécifique.

11. Appareil de surveillance d'énergie selon la revendication 10, dans lequel l'acquéreur est configuré pour acquérir les informations d'utilisation d'énergie via un réseau.

12. Dispositif de surveillance d'énergie selon l'une quelconque des revendications précédentes, comprenant en outre un dispositif de commande configuré pour commander une source d'énergie en utilisant les informations de besoin en énergie délivrées en sortie par le dispositif de sortie.

13. Procédé pour surveiller une consommation d'énergie, le procédé comprenant les étapes consistant à :
acquérir des informations d'utilisation d'énergie à partir d'un dispositif de mesure d'énergie ;
tracer les informations d'utilisation d'énergie provenant du dispositif de mesure d'énergie ;
détecter les fronts montants dans le tracé, et sélectionner une partie des informations d'utilisation d'énergie sur la base des fronts montants détectés ;
générer une image de caractéristique visuelle en utilisant la partie sélectionnée des informations d'utilisation d'énergie ;
analyser l'image de caractéristique visuelle en utilisant la reconnaissance d'image pour détecter une signature de consommation d'énergie de dispositif ; et
délivrer en sortie des informations de besoin en énergie en utilisant la signature détectée de consommation d'énergie de dispositif.

14. Programme informatique qui, lorsqu'il est exécuté par un ordinateur, amène l'ordinateur à effectuer le procédé de surveillance d'une consommation d'énergie selon la revendication 13.

15. Support lisible par ordinateur comprenant le programme informatique selon la revendication 14.
